Europäisches Patentamt

European Patent Office

Office européen des brevets

(19)

(11) **EP 0 668 376 B1**

(12) **FASCICULE DE BREVET EUROPEEN**

(45) Date de publication et mention
de la délivrance du brevet:
**07.04.1999 Bulletin 1999/14**

(51) Int Cl.6: **C30B 25/00**, C30B 29/36,
C30B 29/62, C30B 11/12

(21) Numéro de dépôt: **95400300.0**

(22) Date de dépôt: **14.02.1995**

(54) **Procédé de production de trichites ou whiskers fibreux, longs de carbure de silicium**

Verfahren zur Herstellung langer Siliziumkarbidwhiskern

Process for producing long whiskers of silicon carbide

(84) Etats contractants désignés:
**DE ES GB IT NL SE**

(30) Priorité: **17.02.1994 FR 9401826**

(43) Date de publication de la demande:
**23.08.1995 Bulletin 1995/34**

(73) Titulaires:
• **AEROSPATIALE Société Nationale Industrielle
75781 Paris Cédex 16 (FR)**
• **VIAM ALL Russian Institut of Aviation Materials
107005 Moscou (RU)**

(72) Inventeurs:
• **Gribkov, Vladimir, Nikolaevich
125040 Moscou (RU)**
• **Polakov, Alexandre, Vassilievich
111397 Moscou (RU)**

• **Pokrovcky, Daniel, Danilovich
d. 3a, kv.65 101000 Moscou (RU)**
• **Silaev, Vladimir, Alexandrovich
d. 1, kv. 66 171260 Tverskaja OBL. (RU)**
• **Gorelov, Yurii, Alexeevich
d. 13, kv. 12 171260 Tverskaja OBL. (RU)**
• **Lyacota, Piotr, Phiodorovich
d. 12, kv. 69 171260 Tverskaja OBL. (RU)**

(74) Mandataire: **Lhuillier, René et al
ARMENGAUD JEUNE
CABINET LEPEUDRY
52, avenue Daumesnil
75012 Paris (FR)**

(56) Documents cités:
FR-A- 1 563 415        US-A- 3 622 272
US-A- 4 504 453        US-A- 4 789 536

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

L'invention concerne un procédé de production de trichites ou whiskers de carbure de silicium (SiC) et plus particulièrement de trichites ou whiskers sous forme de longues fibres, qui peuvent être utlisés comme matériaux de renforcement par incorporation dans des composites à base de métaux, des céramiques industrielles, des outils de coupe en céramique, des isolants thermiques etc.

La technologique dominante actuelle pour produire des trichites ou whiskers de SiC est le dépôt chimique en phase vapeur (CVD). Ce procédé est souvent mis en oeuvre en utilisant des réactifs de départ solides ou gazeux et en ayant recours à des réactions chimiques globales telles que :

$$SiO_2 + 3C \rightarrow SiC + 2CO$$

ou

$$SiCl_4 + H_2 + CH_4 \rightarrow SiC + H_2 + 4HCl.$$

En règle générale, pour faire croître des trichites ou whiskers de SiC, c'est-à-dire des monocristaux fins, allongés, le procédé est mis en oeuvre en présence d'éléments qui sont appelés catalyseurs ou solvants. Comme catalyseurs, on utilise souvent les métaux de transition Fe, Ni, Cr, Mn mais d'autres éléments tels que Al, La etc. peuvent aussi être utilisés. Ces éléments peuvent être introduits spécialement dans la zone de réaction ou peuvent être présents, en tant qu'impuretés, dans les composants ou réactifs de départ. Il est également possible d'introduire les éléments solvants en question sous forme de composés variés, par exemple d'oxydes, si, dans le procédé de production de trichites ou whiskers, il existe des conditions qui assurent la transformation du composé concerné en un élément libre.

Le rôle essentiel de l'élément solvant ou catalyseur est de former, dans les conditions de la production de trichites ou whiskers de SiC, des solutions sous forme de masses fondues comprenant du silicium et du carbone, de type Me-Si-C, Me représentant le métal ou les métaux jouant le rôle de solvant ou catalyseur. Dans un tel cas, le dépôt chimique en phase vapeur a lieu de façon prédominante à la surface des gouttelettes de masse fondue selon le mécanisme dit VLS (<u>V</u>apour-<u>L</u>i-quid-<u>S</u>olid process : procédé vapeur-liquide-solide), ce qui assure la croissance axiale unidirectionnelle du SiC sous forme de trichites ou whiskers à partir de la phase gazeuse.

La particularité de tous les procédés de production de trichites ou whiskers, y compris ceux de SiC, réside dans la nécessité de les mettre en oeuvre avec de faibles sursaturations qui sont caractéristiques de la croissance à une dimension. Si au contraire on ne procède pas avec de faibles sursaturations, il se forme des cristaux équiaxiaux, isométriques, des pellicules polycristallines, voire même des précipités pulvérulents, au lieu de trichites ou whiskers. Par conséquent, il est obligatoire que le procédé soit mis en oeuvre avec une phase gazeuse comprenant une faible concentration des réactifs. La conséquence de cette exigence est l'obtention d'un rendement extrêmement faible. Ainsi, pour les trichites ou whiskers de SiC il est, en général, de 0,1 à 1,0 g/m$^2$.h et, dans des cas exceptionnels, il atteint 3 à 5 g/m$^2$.h.

Afin de surmonter cet inconvénient de la production industrielle de trichites ou whiskers de SiC, leur croissance est effectuée dans le volume de corps poreux formant des substrats et présentant une surface spécifique élevée.

Dans de tels cas, en règle générale, on a recours à la réaction :

$$SiO_2 + 3C \rightarrow SiC + 2CO.$$

Il est toutefois également possible de "purger" le substrat poreux avec un mélange gazeux du type SiCl$_4$ + H$_2$ + CH$_4$.

Comme matériau de substrat, on utilise dans ces deux cas de la silice (SiO$_2$) et du carbone désagrégés par différents procédés, ou des substances naturelles ou synthétiques contenant de la silice et du carbone. Les éléments solvants sont soit présents au départ dans les composants initiaux du substrat, soit introduits spécialement dans le substrat.

L'utilisation décrite ci-dessus d'un substrat à haute porosité permet d'atteindre une productivité économiquement acceptable des installations industrielles mais la longueur des trichites ou whiskers de SiC est limitée par les dimensions des pores du substrat.

En général, la longueur des trichites ou whiskers de SiC fabriqués industriellement est de quelques dizaines de microns et ne dépasse par une centaine de microns.

On connaît un procédé permettant de désagréger le substrat en y introduisant un polymère, du carbone ou des fibres céramiques formant un squelette, afin de former des pores plus larges mais, même dans ce cas, la longueur maximale des trichites ou whiskers ne dépasse pas 1 mm.

Compte tenu de l'exposé qui précède, on constate qu'il existe un besoin important de disposer de trichites ou whiskers de SiC ayant des longueurs allant de quelques millimètres à des dizaines, voire des centaines de millimètres, pour différentes applications dans la fabrication subséquente de filaments continus, de tissus, de mats, de feuilles et de produits non-tissés, semi-finis.

Pour la production de trichites ou whiskers d'une telle longueur, il est nécessaire d'assurer un espace libre présentant les dimensions requises et, par conséquent, les substrats poreux deviennent inacceptables. On utilise alors habituellement du graphite massif et, de façon plus rare, des substrats céramiques. La croissance des trichites ou whiskers n'a lieu qu'à l'interface géométrique substrat-gaz. Les réactions chimiques utilisées alors sont du type de la première ou de la seconde indiquées ci-dessus. Un élément solvant est soit déposé directement à la surface du substrat, soit placé séparément dans son voisinage. Avec les procédés qui viennent d'être décrits, il est possible de faire croître des trichites ou whiskers de SiC ayant des longueurs pouvant atteindre 20 à 30 mm et même plus, mais la productivité des procédés les plus efficaces et les plus utilisés ne dépasse pas 5 $g/m^2.h$. D'après les évaluations actuelles, de tels procédés ne peuvent devenir économiquement acceptables que si l'on augmente la productivité d'au moins un facteur 2.

La nécessité d'utiliser un substrat massif, c'est-à-dire une épaisseur suffisamment grande dans le cas du graphite ou des céramiques, fait obstacle à la création d'installations industrielles à grande échelle et on comprendra que pour obtenir des produits suffisamment uniformes il est nécessaire d'assurer des paramètres de procédé aussi constants que possible, en particulier une concentration égale des réactifs dans tout le volume de l'appareil.

La séparation des trichites ou whiskers du substrat représente le problème essentiel, en raison de leur forte liaison avec celui-ci. Le procédé décrit ci-dessus est extrêmement difficile à mécaniser et conduit à une contamination du produit résultant par la matière du substrat.

Par conséquent, l'invention a pour buts :

- d'augmenter la productivité du procédé de préparation de trichites ou whiskers de SiC fibreux longs (5 à 100 mm) jusqu'à des valeurs qui rendent ce procédé économiquement acceptable ;
- de mettre au point une technologie qui puisse être appliquée à des installations industrielles à grande échelle ;
- d'assurer la stabilité de la composition au plan de la concentration et d'autres paramètres de la croissance des trichites ou whiskers dans tout le volume d'un grand appareillage et pendant la durée nécessaire à la production de longs trichites ou whiskers de SiC ;
- de permettre la séparation facile des trichites ou whiskers formés du substrat sans les endommager et sans contaminer le produit résultant par la matière du substrat.

Ces buts sont atteints selon l'invention qui fournit un procédé de production de trichites ou whiskers de SiC et de mats de ceux-ci sur un substrat par traitement thermique, à une température de 1250 à 1500°C, d'un mélange gazeux comprenant de l'hydrogène et des sources d'atomes de Si et C qui sont sous forme d'au moins un composé dépourvu d'oxygène, en présence d'un catalyseur choisi dans le groupe des métaux, par un procédé semi-continu ou périodique, lequel procédé est caractérisé en ce que :

- durant la période de croissance, un catalyseur à deux composants, Al-Fe, est introduit dans la phase gazeuse dans la zone de réaction, au moyen d'une réduction par le carbone de céramiques de type aluminosilicate, lesquelles céramiques comprennent au moins 73 % en poids de $Al_2O_3$ et de 0,3 à 3,0 % en poids d'oxydes de fer ; et
- le substrat est un tissu de carbone à base de fibre de rayonne carbonisée, lequel tissu a été prétraité, avant la carbonisation, par une solution de borax et une solution de phosphate de diammonium jusqu'à ce que la quantité de bore dans le tissu n'atteigne pas plus de 4 % en poids et que la quantité de phosphore n'atteigne pas plus de 2 % en poids.

Selon un premier mode avantageux de réalisation, le procédé selon l'invention est caractérisé en ce qu'il est un procédé semi-continu, mis en oeuvre en acheminant, à travers la zone de réaction, des assemblages pour la croissance de trichites ou whiskers de SiC, lesquels assemblages comprennent des boîtes en graphite à extrémités ouvertes, dans lesquelles sont empilés en parallèle, les uns au-dessus des autres, des plateaux de graphite chargés de céramiques de type aluminosilicate et de carbone et dans lesquelles sont disposés, en alternance entre les plateaux, des substrats constitués de tissu de carbone.

Il est souhaitable que les réactifs gazeux de départ soient introduits sous forme de "purge" dans le sens inverse de celui du mouvement des assemblages pour la croissance de trichites ou whiskers de SiC, à travers la zone de réaction.

Selon un deuxième mode avantageux de réalisation, le procédé selon l'invention est caractérisé en ce qu'il est un procédé périodique, mis en oeuvre dans un four à cuve verticale dans lequel, dans les plans perpendiculaires à la direction du courant gazeux, sont distribués des substrats de tissu de carbone qui sont séparés par une distance de 50 à 300 mm et présentent chacun un orifice central à travers lequel le mélange gazeux de départ est introduit, et dans lequel la charge de céramiques de type aluminosilicate est placée le long du périmètre externe des substrats.

Comme source de silicium libre, il est opportun d'utiliser des composés des types suivants : $SiCl_4$, $SiHCl_3$, $CH_3SiCl_3$ et d'autres composés similaires dépourvus d'oxygène.

Le choix d'un tel composé dépend notamment du type de procédé (semi-continu ou périodique), et du type et des dimensions de la zone de réaction. Lorsque la zone de réaction présente une grande longueur et le mélange gazeux s'écoule à travers la zone de réaction pendant longtemps, il est préférable d'utiliser du SiCl$_4$ moins réactif dans les conditions de température élevées et proches de 1500°C, mais lorsque la zone de réaction est courte, il est préférable d'utiliser CH$_3$SiCl$_3$ ou SiHCl$_3$ aux températures voisines de 1300°C.

Comme source de carbone libre, on utilise avantageusement un hydrocarbure, de préférence le méthane.

La composition normale en concentrations du mélange est la suivante : 0,5 à 2,5 % en volume de SiCl$_4$ ; hydrocarbure en une quantité qui satisfasse le rapport atomique C:Si = 1 à 2 ; l'hydrogène constituant le complément.

On utilise simultanément Al et Fe comme catalyseurs. Dans une telle combinaison, Al qui présente une forte activité catalytique vis-à-vis des réactions à la surface des gouttelettes, assure une croissance axiale rapide et Fe qui est un bon solvant du carbone, minimise les défauts et assure une résistance mécanique élevée aux trichites ou whiskers.

Afin d'avoir une introduction continue et uniforme de Al et Fe dans la zone de réaction pendant une longue durée, on met des céramiques à base d'aluminosilicate ayant la composition indiquée plus haut en contact avec du carbone dans un assemblage en graphite ou dans une charge contenant de la poudre de carbone. Le degré de broyage des céramiques et la quantité de carbone éventuellement introduite sont ajustés en fonction de la température requise et de la composition en composants de départ.

Lorsqu'on utilise des céramiques contenant moins de 73 % en poids d'Al$_2$O$_3$, le produit est contaminé par SiO$_2$ en raison de la réduction plus active de la silice libre par le carbone.

Une diminution de la teneur en oxydes de fer dans les céramiques à une valeur inférieure à 0,3 % en poids conduit à une croissance instable pour former des trichites ou whiskers courts, défectueux et significativement moins résistants.

Une augmentation de la teneur en oxydes de fer jusqu'à une valeur supérieure à 3,0 % en poids conduit à un plus grand diamètre des trichites ou whiskers et à leur contamination par les siliciures de fer en tant qu'impuretés.

Selon la présente invention, on utilise comme substrat un tissu de carbone à base de fibre de rayonne carbonisée, lequel tissu est traité, avant la carbonisation, par des solutions de borax et de phosphate de diammonium. Ce tissu contient jusqu'à 2 % en poids de phosphore et jusqu'à 4 % en poids de bore. Par conséquent, il se produit une modification de surface des fibres de carbone, laquelle modification empêche la formation d'une liaison forte "trichite ou whisker - fibre de carbone" et, de ce fait, les trichites ou whiskers résultants qui se développent sous forme de mats à la surface du substrat sont facilement enlevés sans dommage ni contamination.

Le procédé selon l'invention est mis en oeuvre dans des assemblages comprenant des fours fonctionnant de façon semi-continue ou de façon périodique, en atmosphère d'hydrogène.

Dans les dessins annexés :

- la figure 1 illustre le procédé semi-continu ;
- la figure 2 illustre le procédé périodique.

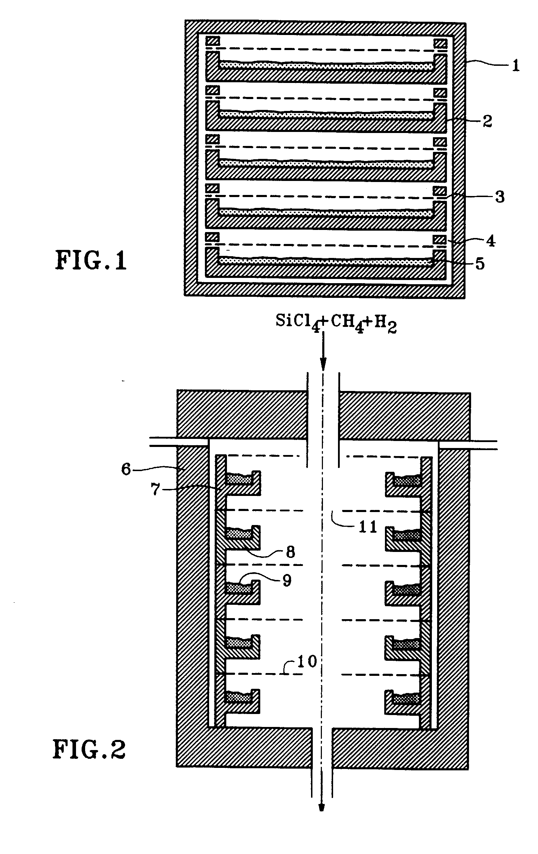

La figure 1 est un dessin qui représente, en coupe transversale, un assemblage pour la croissance de trichites ou whiskers de SiC, comprenant une boîte 1 à section rectangulaire, en graphite, ouverte à ses extrémités, dans laquelle il y a plusieurs plateaux 2 en graphite, alternant avec des substrats 3 constitués de couches de tissu de carbone et des inserts 4 en graphite. La charge 5 comprenant un mélange de mullite et de carbone est placée dans les plateaux.

Le tissu de carbone est disposé de telle sorte que la distance entre la surface de la charge 5 et ledit tissu 3, ainsi que la distance entre la partie inférieure du plateau 2 qui est au-dessus dudit tissu et ledit tissu 3 soient dans la gamme de 10 à 50 mm. Ces distances sont définies par la hauteur de la paroi latérale du plateau 2 et par l'épaisseur de l'insert 4.

Dans le procédé semi-continu, des assemblages pour la croissance de trichites ou whiskers de SiC présentant la construction décrite ci-dessus sont poussés périodiquement, l'un après l'autre, à travers la zone chauffée dans le four, à l'aide de chambres d'écluse ou sas et de mécanismes d'entraînement appropriés.

Le mélange gazeux de départ est introduit à travers la zone de chauffage en sens contraire du mouvement des assemblages pour la croissance. Après passage à travers le four, les assemblages pour la croissance sont déchargés à travers la chambre d'écluse de sortie et les trichites ou whiskers formés sont enlevés. Les trichites ou whiskers croissent principalement sur les deux faces du substrat en tissu de carbone et en sont facilement enlevés sous forme de mats uniformes, sans aucune contamination ni dommage. La longueur des trichites ou whiskers atteint 20 à 30 mm lorsque leur diamètre est dans la gamme de 0,8 à 2,5 μm. La résistance mécanique des trichites ou whiskers est supérieure à 1.104 MPa.

Selon l'invention, dans le procédé semi-continu, les trichites ou whiskers de SiC peuvent aussi croître sous forme de mats principalement orientés avec une orientation unidirectionnelle de 60 à 80 % des trichites ou whiskers. Dans ce but, le procédé est mis en oeuvre comme expliqué ci-dessus mais à condition que la vitesse linéaire des réactifs gazeux de départ à la surface du substrat soit d'au moins 0,2 cm/s dans les conditions normales. La qualité du produit final est comme indiquée plus haut.

Ce procédé assure une productivité de trichites ou whiskers de SiC fibreux et longs de 10 à 15 g/m$^2$.h qui est de 2 à 3 fois supérieure à celle obtenue avec les procédés connus les plus productifs ou performants.

La figure 2 est un dessin qui concerne le procédé périodique. Il représente, en coupe transversale, un four à cuve 6 à atmosphère d'hydrogène, à l'intérieur duquel se trouve un assemblage pour la croissance de trichites ou whiskers de SiC, comprenant des anneaux de graphite 7 présentant des plateaux 8 où est placée la charge 9 de source de catalyseurs, et cet assemblage comprend en outre des substrats 10 en tissu de carbone présentant chacun un orifice central 11 pour le passage des gaz.

Dans la mise en oeuvre prolongée du procédé périodique, la charge 9 ne doit pas contenir de carbone car le contact entre les céramiques de type aluminosilicate et les parois des plateaux en graphite remplissent les conditions requises.

Lors de la mise en oeuvre du procédé périodique, le mélange gazeux de départ est introduit dans l'assemblage par l'entrée centrale dans la partie supérieure du four et les effluents gazeux sont éliminés par l'intermédiaire du raccord à la base du four. Le procédé est mis en oeuvre à une température de 1250 à 1500°C, pendant 10 à 20 heures. Les trichites ou whiskers se développent essentiellement sur les substrats en tissu de carbone 10 et atteignent une longueur de 100 mm et plus, jusqu'à ce que les fronts de croissance opposés, provenant des substrats adjacents, se joignent ensemble. Les mats annulaires volumineux et denses résultants sont facilement enlevés des substrats lorsque l'on désassemble les anneaux. La résistance mécanique moyenne des trichites ou whiskers de SiC ainsi obtenus est de $0,8.10^4$ à $1,5.10^4$ MPa lorsque leur diamètre est de 1 à 2 $\mu$m, et le diamètre moyen des trichites ou whiskers est de 0,5 à 1,5 $\mu$m.

Les exemples suivants sont destinés à illustrer et mieux expliquer l'invention.

Exemple 1 :

Dans des boîtes en graphite ouvertes à leurs extrémités et présentant les dimensions extérieures de 300 x 300 x 300 mm, on met en place, comme montré à la figure 1, trois plateaux en graphite. Entre ces plateaux, on fixe trois couches de tissu de carbone à l'aide d'inserts en graphite.

Les boîtes, les plateaux et les inserts sont en graphite de qualité commerciale. Les substrats en tissu de carbone présentant les dimensions requises sont découpés dans un tissu de carbone fabriqué à partir de fibre de rayonne carbonisée qui a été prétraitée avant la carbonisation par des solutions de borax et de phosphate de diammonium. Le tissu contient 2,5 % en poids de bore et 1,8 % en poids de phosphore.

Tout d'abord, les plateaux en graphite sont remplis avec un mélange broyé (taille moyenne des particules : 0,5 mm) d'aluminosilicate réfractaire et de 5 % en poids de noir de carbone ; l'épaisseur de la couche résultante est de 8 à 10 mm. L'aluminosilicate réfractaire présente la composition en poids suivante : 75 % de $Al_2O_3$ ; 1,4 % de $(FeO + F_2O_3)$ ; complément : $SiO_2$. La phase est composée de mullite et d'$Al_2O_3$ $\alpha$.

La hauteur de l'insert en graphite est prédéterminée de telle sorte que la distance entre le tissu de carbone et la couche de charge céramique, ainsi qu'entre le tissu et la partie inférieure du plateau qui se trouve au-dessus soit de 25 mm.

Lorsque les assemblages pour la croissance de trichites ou whiskers sont prêts, ils sont chargés dans un four tunnel à fonctionnement semi-continu, par l'intermédiaire d'une chambre d'écluse sous vide et sont poussés l'un après l'autre avec une période de 1 assemblage par heure.

Le four en question présente une section transversale rectangulaire du conduit ayant les dimensions de 350 x 350 mm et une longueur de zone à une température uniforme de 500 à 600 mm. Les corps de chauffe et les parois du four sont en graphite de qualité commerciale. La température dans le four est maintenue à 1350 ± 25°C.

Le mélange gazeux de départ comprenant 1,2 % en volume de $CH_3SiCl_3$, le complément étant constitué par de l'hydrogène, est introduit à un débit de 2,5 $m^3$/h dans le sens inverse du mouvement des assemblages pour la croissance des trichites ou whiskers. Les gaz d'échappement sont purifiés, à partir des produits de réaction gazeux, dans un absorbeur, puis ils sont neutralisés pour éliminer HCl et enfin l'hydrogène est brûlé.

Dans les conditions décrites ci-dessus, chaque assemblage pour la croissance reste pendant 2 heures dans la zone du four présentant une température maximale de 1350°C.

Après passage dans la zone active ou de travail et refroidissement pendant le mouvement subséquent à travers une chambre de refroidissement, tous les assemblages pour la croissance sont extraits du four à l'aide d'une chambre d'écluse de sortie sous vide, puis les trichites ou whiskers formés et la charge qui n'a pas réagi sont enlevés des assemblages.

La quantité de trichites ou whiskers formés sur les substrats en tissu de carbone est de 5,5 g, et 1,5 à 2,0 g supplémentaires se trouvent sur les parois de la boîte et des plateaux.

Sur les substrats en tissu de carbone, les trichites ou whiskers croissent sous forme de mats à deux faces, d'épaisseur et de densité uniformes. Dans ces mats, 60 à 70 % des trichites ou whiskers ont une orientation unidirectionnelle, dans la même direction que le courant gazeux. Tous les mats sont facilement enlevés des substrats. Le diamètre moyen des trichites ou whiskers dans les mats est de 1,0 $\mu$m et la gamme des diamètres est de 0,5 à 3,0 $\mu$m. La longueur maximale des trichites ou whiskers est de 30 mm et leur longueur moyenne est de 5 à 6 mm. La résistance mécanique déterminée est d'au moins $1,2.10^4$ MPa.

Exemple 2 :

Un assemblage pour la croissance de trichites ou whiskers de SiC tel que représenté à la figure 2 est placé dans un four à cuve muni de corps de chauffe et de parois latérales en graphite. Cet assemblage comprend 16 anneaux en graphite. Le diamètre extérieur d'un anneau est de 700 mm et sa hauteur est de 100 mm. Cet assemblage comprend également 15 substrats annulaires en tissu de carbone présentant chacun un orifice central ayant un diamètre de 200 mm. Ces substrats sont découpés dans un tissu en carbone ayant la même composition que celui de l'exemple 1.

Une charge comprenant de l'aluminosilicate granulaire, réfractaire ayant la même composition que dans l'exemple 1 est placée sur les plateaux de l'assemblage. La taille des particules de l'aluminosilicate est de 3 à 5 mm.

Le four, dans lequel l'assemblage ainsi chargé est inséré, est purgé avec de l'azote jusqu'à élimination totale de l'air. Le four est ensuite chauffé à 1430°C en atmosphère d'hydrogène, après quoi un mélange gazeux comprenant 2,0 % en volume de $SiCl_4$, 2,5 % en volume de méthane et de l'hydrogène pour constituer le complément est introduit par l'intermédiaire de l'entrée centrale à un débit de 8 m³/h. Les gaz d'échappement sont éliminés par la partie inférieure du four, à la suite de quoi ils sont purifiés dans un absorbeur et neutralisés, puis l'hydrogène est brûlé. Le procédé est mis en oeuvre pendant 16 heures. Lorsque le processus est terminé, l'introduction du mélange gazeux est arrêtée et le four est refroidi dans une atmosphère d'azote. L'assemblage pour la croissance des trichites ou whiskers est extrait du four et désassemblé après refroidissement complet.

Des mats annulaires volumineux, comprenant des trichites ou whiskers de SiC ayant jusqu'à 50 mm de long, sont facilement enlevés des espaces entre les substrats adjacents. La quantité totale de trichites ou whiskers est de 1,0 à 1,1 kg. Le diamètre moyen des trichites ou whiskers est de 0,5 à 1,5 µm et leur résistance mécanique est d'au moins 8000 MPa.

## Revendications

1. Procédé de production de trichites ou whiskers de SiC et de mats de ceux-ci sur un substrat par traitement thermique, à une température de 1250 à 1500°C, d'un mélange gazeux comprenant de l'hydrogène et des sources d'atomes de Si et C qui sont sous forme d'au moins un composé dépourvu d'oxygène, en présence d'un catalyseur choisi dans le groupe des métaux, par un procédé semi-continu ou périodique, lequel procédé est caractérisé en ce que :

   - durant la période de croissance, un catalyseur à deux composants, Al-Fe, est introduit dans la phase gazeuse dans la zone de réaction, au moyen d'une réduction par le carbone de céramiques de type aluminosilicate, lesquelles céramiques comprennent au moins 73 % en poids de $Al_2O_3$ et de 0,3 à 3,0 % en poids d'oxydes de fer ; et

   - le substrat est un tissu de carbone à base de fibre de rayonne carbonisée, lequel tissu a été prétraité, avant la carbonisation, par une solution de borax et une solution de phosphate de diammonium jusqu'à ce que la quantité de bore dans le tissu n'atteigne pas plus de 4 % en poids et que la quantité de phosphore n'atteigne pas plus de 2 % en poids.

2. Procédé selon la revendication 1, caractérisé en ce qu'il est un procédé semi-continu, mis en oeuvre en acheminant, à travers la zone de réaction, des assemblages pour la croissance de trichites ou whiskers de SiC, lesquels assemblages comprennent des boîtes (1) en graphite à extrémités ouvertes, dans lesquelles sont empilés en parallèle, les uns au-dessus des autres, des plateaux (2) de graphite chargés de céramiques de type aluminosilicate et de carbone (5) et dans lesquelles sont disposés, en alternance entre les plateaux, des substrats (3) constitués de tissu de carbone.

3. Procédé selon la revendication 2, caractérisé en ce que la distance entre la surface de la charge (5) et le substrat (3), ainsi que la distance entre la partie inférieure du plateau (2) qui est au-dessus dudit substrat (3) et ledit substrat (3) sont dans la gamme de 10 à 50 mm.

4. Procédé selon la revendication 2 ou 3, caractérisé en ce que les réactifs gazeux de départ sont introduits sous forme de "purge" dans le sens inverse de celui du mouvement des assemblages pour la croissance de trichites ou whiskers de SiC, à travers la zone de réaction.

5. Procédé selon l'une quelconque des revendications 2 à 4, caractérisé en ce que, afin de produire des mats de trichites ou whiskers de SiC avec une orientation principalement unidirectionnelle, la vitesse linéaire des réactifs gazeux de départ à la surface du substrat est réglée à au moins 0,2 cm/s dans les conditions normales.

6. Procédé selon la revendication 1, caractérisé en ce qu'il est un procédé périodique, mis en oeuvre dans un four à cuve verticale (6) dans lequel, dans les plans perpendiculaires à la direction du courant gazeux, sont distribués des substrats (10) de tissu de carbone qui sont séparés par une distance de 50 à 300 mm et présentent chacun un orifice central (11) à travers lequel le mélange gazeux de départ est introduit, et dans lequel la charge (9) de céramiques de type aluminosilicate est placée le long du périmètre externe des substrats.

7. Mats de trichites ou whiskers obtenus par mise en oeuvre du procédé selon la revendication 5, caractérisés en ce que les trichites ou whiskers dont ils sont formés présentent une orientation unidirectionnelle en une proportion pouvant atteindre 80 %.

**Patentansprüche**

1. Verfahren zur Herstellung von Trichiten oder Whiskern aus SiC sowie von Vliesen aus denselben auf einem Substrat mittels einer bei einer Temperatur von 1250 bis 1500°C stattfindenden thermischen Behandlung einer gasförmigen, Wasserstoff und Si- und C-Atomquellen in Form mindestens einer sauerstoffarmen Verbindung umfassenden Mischung in Gegenwart eines aus der Gruppe der Metalle ausgewählten Katalysators in einem halbkontinuierlichen oder periodischen Verfahren, wobei das Verfahren dadurch gekennzeichnet ist, daß

   - im Verlauf der Wachstumsperiode mittels Reduktion von Keramik des Aluminiumsilikattyps durch Kohlenstoff ein Katalysator aus zwei Komponenten, Al-Fe, in die Gasphase in der Reaktionszone gebracht wird, wobei die Kera- mik mindestens 73 Gew.-% $Al_2O_3$ und 0,3 bis 3 Gew.-% Eisenoxide aufweist; und

   - das Substrat ein Kohlenstoffgewebe auf Basis carbonisierter Viskosefasern ist, welches vor der Carbonisation mit einer Boraxlösung und einer Diammoniumphosphatlösung solange vorbehandelt worden ist, bis im Gewebe ein Gehalt bis zu 4 Gew.-% an Bor und bis zu Gew.- % an Phosphor erreicht worden war.

2. Verfahren nach Anspruch 1, dadurch gekennzeichnet, daß es ein halbkontinuierliches Verfahren ist, welches dadurch erfolgt, daß durch die Reaktionszone Anordnungen für das Wachstum der Trichite und Whisker aus SiC geführt werden, welche an den Enden offene Gehäuse (1) aus Graphit aufweisen, in denen Keramik des Aluminiumsilikattyps und Kohlenstoff (5) enthaltende Tabletts (2) aus Graphit übereinander und parallel zueinander gestapelt sind, wobei in den Gehäusen, in regelmäßiger Abfolge zwischen den Tabletts, aus Kohlenstoffgewebe bestehende Substrate (3) angeordnet sind.

3. Verfahren nach Anspruch 2, dadurch gekennzeichnet, daß der Abstand zwischen der Oberfläche des Inhalts (5) und dem Substrat (3) sowie der Abstand zwischen der über dem Substrat (3) befindlichen Unterseite des Tabletts (2) und dem Substrat (3) zwischen 10 und 50 mm beträgt.

4. Verfahren nach Anspruch 2 oder 3, dadurch gekennzeichnet, daß die reaktiven gasförmigen Ausgangsstoffe durch die Reaktionszone in Form einer „Entlüftung" umgekehrt zur Bewegungsrichtung der Anordnungen für das Wachstum der Trichite und Whisker aus SiC geleitet werden.

5. Verfahren nach einem der Ansprüche 2 bis 4, dadurch gekennzeichnet, daß zur Herstellung von Vliesen aus SiC-Trichiten oder -Whiskern mit einer im wesentlichen in eine Richtung weisenden Aus- richtung die Durchflußgeschwindigkeit der reakti- ven gasförmigen Ausgangsstoffe auf der Substratoberfläche auf mindestens 0,2 cm/sec unter Normalbedingungen eingestellt wird.

6. Verfahren nach Anspruch 1, dadurch gekennzeichnet, daß es ein periodisches Verfahren ist, welches in einem senkrechten Wannenofen (6) erfolgt, in dem in den Ebenen senkrecht zur Richtung des Gasstroms Substrate (10) aus Kohlengewebe angeordnet sind, welche mit einem Abstand von 50 bis 300 mm voneinander getrennt sind und jeweils eine zentrale Öffnung (11) aufweisen, durch welche die gasförmige Ausgangsmischung geführt wird, und in welchem Ofen der Inhalt (9) aus Keramik des Aluminiunsilikattyps entlang dem Außenumfang der Substrate untergebracht ist.

7. Vliese aus Trichiten oder Whiskern, erhalten nach der Durchführung des Verfahrens gemäß Anspruch 5, dadurch gekennzeichnet, daß die Trichite oder Whisker, aus denen sie gebildet sind, mit bis zu 80% reichendem Anteil eine in eine Richtung zeigende Ausrichtung aufweisen.

**Claims**

1. Process for the production of SiC whiskers and of mats thereof on a substrate by heat treatment, at a temperature of 1250 to 1500°C, of a gaseous mixture including hydrogen and sources of Si and C atoms which are in the form of at least one oxygen- free compound, in the presence of a catalyst chosen from the group of metals, by a semi-continuous or periodic process, which process is characterized in that:

   - during the growth period, a two-component catalyst, Al-Fe, is introduced into the gas phase in the reaction zone, by means of a carbon reduction of aluminosilicate ceramics, which ceramics comprise at least 73 weight % of $Al_2O_3$ and

**EP 0 668 376 B1**

0.3 to 3.0 weight % of iron oxides; and

- the substrate is a carbonized rayon fiber based carbon fabric, which fabric has been pre-treated, prior to carbonization, with a solution of borax and a solution of diammonium phosphate until the quantity of boron in the fabric does not amount to more than 4 weight % and the quantity of phosphorus does not amount to more than 2 weight %.

2. Process according to claim 1, characterized in that it is a semi-continuous process, conducted by transporting, through the reaction zone, SiC whisker growing assemblies, which assemblies comprise open-ended graphite boxes (1) in which are stacked in parallel, one above the other, graphite trays (2) with charges of aluminosilicate ceramics and carbon (5) and in which there are disposed, alternating between the trays, substrates (3) made of carbon fabric.

3. Process according to claim 2, characterized in that the distance between the surface of the charge (5) and the substrate (3), as well as the distance between the lower portion of the tray (2) which is above the said substrate (3) and the said substrate (3) are in the range of 10 to 50 mm.

4. Process according to claim 2 or 3, characterized in that the initial gaseous reactants are introduced in the form of a "purge" in the direction opposite to that of the movement of the SiC whisker growing assemblies, through the reaction zone.

5. Process according to any one of claims 2 to 4, characterized in that, in order to produce mats of SiC whiskers with primarily unidirectional orientation, the linear velocity of the initial gaseous reactants over the surface of the substrate is adjusted to at least 0.2 cm/s under normal conditions.

6. Process according to claim 1, characterized in that it is a periodic process, implemented in a vertical shaft furnace (6) in which, in the planes perpendicular to the direction of the gas flow, there are distributed substrates (10) of carbon fabric which are separated by a distance of 50 to 300 mm and each have a central hole (11) through which the initial gas mixture is introduced, and in which the charge (9) of aluminosilicate ceramics is placed along the outer perimeter of the substrates.

7. Mats of whiskers obtained by carrying out the process according to claim 5, characterized in that the whiskers of which they are formed have a unidirectional orientation in a proportion that can attain 80%.

FIG.1

1

2

3

4

5

$SiCl_4 + CH_4 + H_2$

6

7

8

9

11

10

FIG.2